# EUROPÄISCHE PATENTSCHRIFT

(11) **EP 2 909 876 B1**
(45) Veröffentlichungstag und Bekanntmachung des Hinweises auf die Patenterteilung: **19.10.2016**
(21) Anmeldenummer: 14701570.5
(22) Anmeldetag: 28.01.2014
(51) Int. Cl.: H01M 2/02, H01M 2/10, H05K 3/32, H01R 13/24, H01M 2/20, H01M 2/04, B60C 23/04, H05K 3/34

(54) **KNOPFZELLE, INSBESONDERE FÜR EINEN REIFENDRUCKSENSOR**
BUTTON CELL, IN PARTICULAR FOR A TYRE PRESSURE SENSOR
PILE BOUTON, NOTAMMENT POUR CAPTEUR DE PRESSION DE PNEUMATIQUE

(30) Priorität: 28.01.2013 DE 102013001371
(43) Veröffentlichungstag der Anmeldung: 26.08.2015
(73) Patentinhaber: Alligator Ventilfabrik GmbH, 89537 Giengen (DE)
(72) Erfinder: MARKERT, Christian, 89542 Herbrechtingen (DE)
(74) Vertreter: Dr. Weitzel & Partner
(86) Internationale Anmeldenummer: PCT/EP2014/051662
(87) Internationale Veröffentlichungsnummer: WO 2014/114815

(56) Entgegenhaltungen:
- DE-A1-102007 018 259
- GB-A- 2 314 461
- JP-U- S59 134 267
- US-A1- 2011 001 618

## Beschreibung

Die vorliegende Erfindung betrifft eine Knopfzelle, insbesondere für einen Reifendrucksensor, sowie einen Reifendrucksensor mit einer solchen Knopfzelle.

Knopfzellen werden immer dann zur elektrischen Stromversorgung verwendet, wenn ein nur kleiner Aufnahmeraum für Batterien zur Verfügung steht. Knopfzellen weisen zwei flächige Stirnseiten auf, von denen jede einen elektrischen Pol bildet, nämlich in der Regel die erste Seite einen positiven Pol und die zweite Seite einen negativen Pol.

Herkömmlich erfolgt die Kontaktierung einer Knopfzelle durch einen ersten elektrischen Kontakt, der die erste Stirnseite berührt, und einen zweiten elektrischen Kontakt, der die zweite Stirnseite berührt. Auf diese Art können mehrere Knopfzellen auch in Reihe zueinander geschaltet werden, indem sie einfach aufeinander gestapelt werden.

Bei der Verwendung von Knopfzellen in Reifendrucksensoren, wie sie die vorliegende Erfindung besonders betrifft, ist ein elektrischer Anschluss der Knopfzelle mit beiden Polen in nur einer einzigen gemeinsamen Ebene, in der Regel auf einer Platine, erforderlich. In der Praxis ist man daher dazu übergegangen, auf jeder der beiden Stirnseiten eine Kontaktfahne anzubringen, insbesondere anzuschweißen oder aufzukleben, wobei die eine Kontaktfahne auf der der Platine zugewandten Seite eine im Wesentlichen ebene Form aufweisen kann und die andere auf der der Platine abgewandten Stirnseite der Knopfzelle eine abgewinkelte Form haben muss, da sie sich von dieser abgewandten Stirnseite, sozusagen um den äußeren Rand der Knopfzelle herum bis in die Ebene auf der Platine erstreckt, in der auch die erste Kontaktfahne verläuft. Durch das Herüberführen der zweiten Kontaktfahne in die Ebene der ersten Kontaktfahne besteht naturgemäß die Gefahr, dass sich ein elektrischer Kurzschluss am äußeren Umfang der Knopfzelle ergibt, da sich der durch die erste, hier untere Stirnseite gebildete Pol in der Regel bis auf den äußeren Umfang der Knopfzelle und von dort ein Stück in Richtung des anderen Pols erstreckt. Um einen solchen Kurzschluss zu vermeiden, ist man dazu übergegangen, über den äußeren Umfang der Knopfzelle einfach einen nichtleitenden Schrumpfschlauch überzuziehen und somit eine Isolierung zwischen der zweiten Kontaktfahne und dem äußeren Umfang sicherzustellen.

Obwohl die genannte Ausführungsform zunächst einwandfrei arbeitet, hat sich beim Einsatz der Knopfzelle in Reifendrucksensoren eine überraschend kurze Lebensdauer der Knopfzelle in der Praxis herausgestellt, das heißt, dass die Knopfzelle unerwartet früh entladen ist. Die Ursache hierfür war zunächst nicht bekannt.

Der vorliegenden Erfindung liegt die Aufgabe zugrunde, eine Knopfzelle, insbesondere für einen Reifendrucksensor, anzugeben, bei welcher die Lebensdauer gegenüber den bekannten Ausführungsformen verlängert ist.

Die erfindungsgemäße Aufgabe wird durch eine Knopfzelle mit den Merkmalen von Anspruch 1 gelöst. In den abhängigen Ansprüchen sind vorteilhafte Ausgestaltungen sowie ein erfindungsgemäßer Reifendrucksensor angegeben.

Eine erfindungsgemäße Knopfzelle, insbesondere für einen Reifendrucksensor, weist einen ersten durch eine erste Stirnseite ausgebildeten elektrischen Pol und einen zweiten durch eine zweite zur ersten Stirnseite entgegengesetzte zweite Stirnseite ausgebildeten elektrischen Pol auf. Auf der ersten Stirnseite ist eine erste Kontaktfahne angebracht und auf der zweiten Stirnseite ist eine zweite Kontaktfahne angebracht. Die Kontaktfahne auf der ersten Stirnseite weist eine im Wesentlichen ebene Erstreckung auf, innerhalb welcher Ebene auch die erste Stirnseite verläuft. Dies bedeutet nicht zwingend, dass die erste Kontaktfahne vollständig eben ist. Vielmehr kann die Anschlussebene, in welcher die erste Kontaktfahne zur Kontaktierung der Knopfzelle angeschlossen ist, auch etwas außerhalb der Ebene der ersten Stirnseite liegen.

Die zweite Kontaktfahne erstreckt sich von der Ebene der zweiten Stirnseite, auf welcher sie angebracht ist, bis in die Kontaktierungsebene der ersten Kontaktfahne, das heißt im Wesentlichen bis in die Ebene der ersten Stirnseite. Somit ist es möglich, beide Kontaktfahnen zum elektrischen Anschluss der Knopfzelle in einer gemeinsamen Ebene zu kontaktieren beziehungsweise in zwei nahe beieinander liegenden Ebenen.

Zusätzlich oder alternativ zum Anbringen einer ersten Kontaktfahne auf der ersten Stirnseite der Knopfzelle kann die Stirnseite selbst die Kontaktfahne ausbilden. In diesem Fall erfolgt die Kontaktierung der Knopfzelle über die Stirnseite selbst, beispielsweise auf einem entsprechenden Anschluss einer Platine.

Zumindest im Bereich (Umfangsabschnitt) der ersten und der zweiten Kontaktfahne und insbesondere über dem gesamten äußeren Umfang der Knopfzelle ist eine Isolierungsschicht auf die Knopfzelle aufgebracht, um zu verhindern, dass ein elektrischer Kurzschluss zwischen dem äußeren Umfang und der zweiten Kontaktfahne entsteht.

Erfindungsgemäß weist die Isolierungsschicht nun eine Vielzahl von Öffnungen auf, die die Isolierungsschicht vollständig durchdringen und über der Oberfläche der Isolierungsschicht verteilt angeordnet sind. Beispielsweise ist die Isolierungsschicht als Netz, insbesondere als aufgezogener Netzschlauch, beispielsweise Schrumpfnetzschlauch, ausgeführt.

Der Erfindung liegt die Erkenntnis zugrunde, dass bei den bekannten geschlossenen Isolierungsschichten, insbesondere aufgrund von Temperaturschwankungen, Feuchtigkeit in den Spalt zwischen der Isolierungsschicht und dem äußeren Umfang der Knopfzelle eindringen konnte und dadurch ein Kurzschluss hergestellt wurde, der zu einer ungewollten Entladung der Knopfzelle führt. Aufgrund der geschlossenen Oberfläche der Isolierungsschicht konnte diese Feuchtigkeit nicht entweichen. Durch die erfindungsgemäße Ausführung hingegen kann eine Entlüftung des Spaltes zwischen der Isolierungsschicht und der Knopfzelle sichergestellt werden, die entweder das Bilden eines elektrisch leitenden Feuchtigkeitsfilms vollständig verhindert oder zumindest ein schnelles Trocknen durch Entweichen der Feuchtigkeit ermöglicht, wenn eine solche aufgetreten ist.

Die erste Kontaktfahne und/oder die zweite Kontaktfahne kann die Isolierungsschicht auch durchdringen, beispielsweise durch eine der in dieser vorgesehenen Öffnungen, insbesondere durch eine Netzmasche. Wenn hierdurch die Kontaktfahne teilweise durch die Isolierungsschicht überdeckt ist, kann eine zusätzliche Isolation gegenüber der Umgebung erreicht werden, ohne dass die Kontaktierung erschwert wird.

Ein erfindungsgemäßer Reifendrucksensor weist ein Gehäuse, einen Druckaufnehmer, eine Sendeelektronik sowie eine Stromversorgung auf. Druckaufnehmer, Sendeelektronik und/oder Stromversorgung sind vorteilhaft innerhalb des Gehäuses aufgenommen, teilweise oder vollständig. Die Erfindung ist hierauf jedoch nicht beschränkt. Andere Ausführungsformen sehen eine Montage von einem oder dem anderen Bauteil am Gehäuse oder auch außerhalb des Gehäuses vor.

Die Stromversorgung umfasst eine erfindungsgemäße Knopfzelle.

Insbesondere wenn neben der Stromversorgung auch der Druckaufnehmer und die Sendeelektronik innerhalb des Gehäuses positioniert sind und vom Gehäuse teilweise oder vollständig umschlossen werden, ist es günstig, wenn das Gehäuse mit einer Vergussmasse ausgegossen ist, um dieses bis auf eine Öffnung zum Leiten des Umgebungsdruckes zu dem Druckaufnehmer abzudichten. Die Vergussmasse kann beispielsweise über der gesamten Grundfläche des Gehäuses eingebracht sein.

Durch die erfindungsgemäße Ausführung der Knopfzelle kann nun der zweite Isolator besonders dicht zum äußeren Umfang der Knopfzelle abgewinkelt werden und damit die notwendige Erstreckung der Knopfzelle bis zu den elektrischen Kontaktierungspunkten insbesondere auf einer Platine innerhalb des Gehäuses, die auch den Druckaufnehmer und die Sendeelektronik aufnimmt, minimiert werden. Dies führt dazu, dass das Gehäuse insgesamt kleiner ausgeführt werden kann und somit weniger Vergussmasse benötigt wird. Als Faustregel gilt, dass, wenn das Gehäuse beispielsweise zwei Millimeter länger ausgeführt werden muss, fünf Gramm Vergussmasse mehr erforderlich sind, was bei den üblichen großen Stückzahlen des als Serienbauteil hergestellten Reifendrucksensors zu deutlichen Kosteneinsparungen führt.

Die Knopfzelle kann beispielsweise mit beiden Kontaktfahnen auf einer Platine innerhalb des Gehäuses aufgelötet sein, an welcher auch der Druckaufnehmer und die Sendeelektronik kontaktiert ist.

Günstig ist es, wenn das Gehäuse gelenkig an einem Reifenventil oder einer sonstigen an einer Felge eines Fahrzeugreifens zu befestigenden Aufnahme angeschlossen ist, damit bei verschiedenen Felgentypen immer ein Anschmiegen des Gehäuses an die Seitenwange sichergestellt ist.

Die Erfindung soll nachfolgend anhand eines Ausführungsbeispiels und den Figuren exemplarisch beschrieben werden.

Es zeigen:
- Figur 1: eine schematische Darstellung einer Schnittansicht einer erfindungsgemäßen Knopfzelle;
- Figur 2: eine schematische Darstellung einer Draufsicht auf die Knopfzelle aus der Figur 1;
- Figur 3: einen Reifendrucksensor mit einer erfindungsgemäßen Knopfzelle.

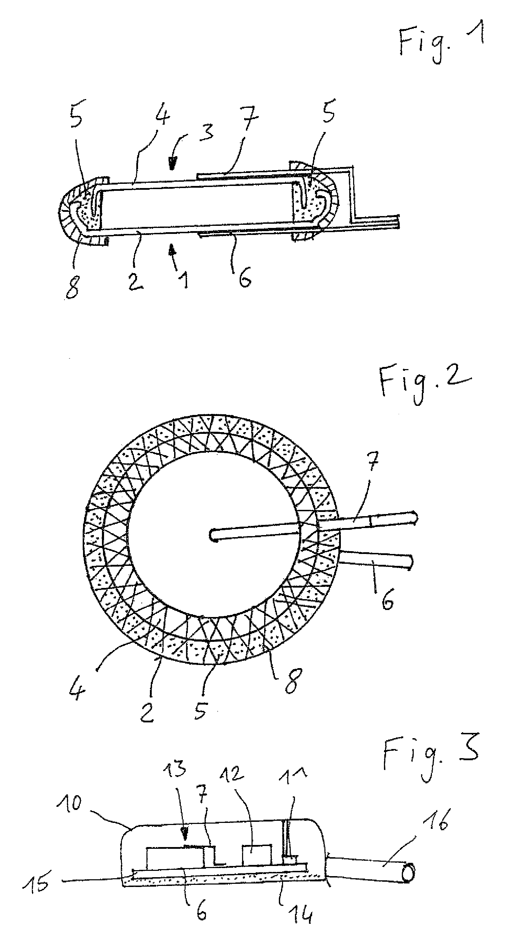

In der Figur 1 ist der innere Aufbau einer Knopfzelle nur angedeutet. Dargestellt ist eine erste elektrisch leitfähige Platte, welche die erste Stirnseite 1 der Knopfzelle und damit den ersten elektrischen Pol 2 ausbildet. Entgegengesetzt zu der ersten Platte ist eine zweite elektrisch leitende Platte vorgesehen, welche die zweite Stirnseite 3 und damit den zweiten elektrischen Pol 4 ausbildet.

Die beiden elektrisch leitenden Platten und damit die elektrischen Pole 2, 4 sind mittels einer Isolationsmasse 5, die im Bereich des äußeren Umfangs der Knopfzelle in diese eingebracht ist, gegeneinander isoliert.

Auf der ersten Stirnseite 1 ist eine erste Kontaktfahne 6 elektrisch leitend mit dem ersten elektrischen Pol 2 verbunden. Die erste Kontaktfahne 6 erstreckt sich im Wesentlichen innerhalb einer Ebene der ersten Stirnseite 1.

Auf der zweiten Stirnseite 3 ist eine zweite Kontaktfahne 7 vorgesehen, die mit dem zweiten elektrischen Pol 4 elektrisch leitend verbunden ist. Diese zweite Kontaktfahne 7 erstreckt sich im Wesentlichen innerhalb der Ebene der zweiten Stirnseite 3 bis über den äußeren Umfang der Knopfzelle heraus, ist dann abgewinkelt, sodass sie in die Ebene im Wesentlichen der ersten Stirnseite 1 eintritt und dort weiter verläuft. Dies hat den Grund, dass die Knopfzelle dazu vorgesehen ist, auf einer Platine (nicht dargestellt) kontaktiert zu werden, wobei die beiden Kontaktstellen der Platine für die beiden elektrischen Pole 2, 4 der Knopfzelle im Wesentlichen innerhalb einer gemeinsamen Ebene liegen.

Wie man sieht, erstreckt sich der erste elektrische Pol 2 von der ersten Stirnseite 1 am äußeren Umfang der Knopfzelle in Richtung der zweiten Stirnseite 4. Das bedeutet, dass auch am äußeren Umfang der Knopfzelle über eine gewisse Höhe, beispielsweise bis zur Hälfte der Höhe oder hierüber hinaus, eine Kontaktierung mit dem ersten elektrischen Pol 2 erfolgen kann. Um nun zu verhindern, dass ein elektrischer Kurzschluss dadurch entsteht, dass die zweite Kontaktfahne 7 am äußeren Umfang der Knopfzelle den ersten elektrischen Pol 1 berührt, ist über dem äußeren Umfang der Knopfzelle eine Isolierungsschicht 8 aufgebracht. Diese Isolierungsschicht 8 erstreckt sich über der gesamten Höhe der Knopfzelle und von außen bis über den äußeren Rand der Stirnseiten 1, 3 und die beiden elektrischen Pole 2, 4 hinweg.

Erfindungsgemäß weist die Isolierungsschicht nun eine Vielzahl von Öffnungen auf beziehungsweise ist im gezeigten Ausführungsbeispiel als aufgezogenes Netz ausgeführt

In der Figur 2 wird die netzartige Struktur der Isolierungsschicht 8 nochmals deutlich und man erkennt, dass diese sich vom äußeren Umfang der Knopfzelle über die Isolationsmasse 5 hinweg bis auf den zweiten elektrischen Pol 4 erstreckt.

In der Figur 2 wird ferner deutlich, dass die erste Kontaktfahne 6 und die zweite Kontaktfahne 7 in Umfangsrichtung der Knopfzelle versetzt zueinander angeordnet sind. Ferner durchdringen beide Kontaktfahnen 6, 7 die Isolierungsschicht 8.

In der Figur 3 ist schematisch ein Reifendrucksensor mit einem Gehäuse 10 dargestellt, welches gelenkig an einem Reifenventil 16 angeschlossen ist.

Innerhalb des Gehäuses 10 ist eine Platine 15 vorgesehen, welche eine Knopfzelle (Stromversorgung 13), eine Sendeelektronik 12 und einen Druckaufnehmer 11 trägt und elektrisch miteinander kontaktiert. Die Knopfzelle ist über die beiden elektrischen Kontaktfahnen 6, 7 an der Platine 15 angeschlossen. In dem hier gezeigten Ausführungsbeispiel wird die erste Kontaktfahne 6 durch die untere Stirnseite der Knopfzelle selbst gebildet.

Das Gehäuse 10 ist mit einer Vergussmasse 14 ausgegossen, um dieses gegenüber der Umgebung abzudichten, mit Ausnahme der luftführenden Verbindung für den Druckaufnehmer 11, in welcher eine Membran vorgesehen sein könnte.

Obwohl dies im Einzelnen nicht dargestellt ist, ist die Knopfzelle mit einer erfindungsgemäßen Isolierungsschicht versehen.

## Patentansprüche

1. Knopfzelle, insbesondere für einen Reifendrucksensor, mit einem ersten durch eine erste Stirnseite (1) ausgebildeten elektrischen Pol (2) und einem zweiten durch eine zur ersten Stirnseite (1) entgegengesetzte zweite Stirnseite (3) ausgebildeten elektrischen Pol (4);
mit einer ersten, auf der ersten Stirnseite (1) angebrachten Kontaktfahne (6), die eine im Wesentlichen ebene Erstreckung innerhalb der Ebene der ersten Stirnseite (1) aufweist, oder mit einer durch die erste Stirnseite (1) ausgebildeten ersten Kontaktfahne (6);
mit einer zweiten, auf der zweiten Stirnseite (3) angebrachten Kontaktfahne (7), die sich von der Ebene der zweiten Stirnseite (3) abgewinkelt im Wesentlichen bis in die Ebene der ersten Stirnseite (1) erstreckt;
mit einer auf die Knopfzelle, zumindest im Bereich der ersten und zweiten Kontaktfahnen (6, 7) aufgebrachten oder über dem äußeren Umfang der Knopfzelle aufgebrachten Isolierungsschicht (8);
**dadurch gekennzeichnet, dass**
die Isolierungsschicht (8) eine Vielzahl von Öffnungen aufweist, die die Isolierungsschicht (8) vollständig durchdringen und die über der Oberfläche der Isolierungsschicht (8) verteilt angeordnet sind.

2. Knopfzelle gemäß Anspruch 1, **dadurch gekennzeichnet, dass** die Isolierungsschicht (8) als Netz ausgeführt ist.

3. Knopfzelle gemäß einem der Ansprüche 1 oder 2, **dadurch gekennzeichnet, dass** die Isolierungsschicht (8) als auf die Knopfzelle aufgezogener Netzschlauch, insbesondere Schrumpfnetzschlauch, ausgeführt ist.

4. Knopfzelle gemäß einem der Ansprüche 1 bis 3, **dadurch gekennzeichnet, dass** die erste und/oder die zweite Kontaktfahne (6, 7) die Isolierungsschicht (8) durchdringt und teilweise von der Isolierungsschicht (8) überdeckt ist.

5. Reifendrucksensor
mit einem Gehäuse (10);
mit einem Druckaufnehmer (11) außerhalb, am oder innerhalb des Gehäuses (10);
mit einer Sendeelektronik (12) am oder innerhalb des Gehäuses (10); mit einer Stromversorgung (13);
**dadurch gekennzeichnet, dass**
die Stromversorgung (13) eine Knopfzelle gemäß einem der Ansprüche 1 bis 4 umfasst.

6. Reifendrucksensor gemäß Anspruch 5, **dadurch gekennzeichnet, dass** der Druckaufnehmer (11), die Sendeelektronik (12) und die Knopfzelle innerhalb des Gehäuses (10) positioniert sind und das Gehäuse (10) zumindest teilweise, insbesondere über seiner gesamten Grundfläche mit einer Vergussmasse (14) ausgegossen ist.

7. Reifendrucksensor gemäß einem der Ansprüche 5 oder 6, **dadurch gekennzeichnet, dass** im Gehäuse (10) eine Platine (15) vorgesehen ist, auf welcher die Knopfzelle mit beiden Kontaktfahnen (6, 7) aufgelötet, aufgeklemmt oder anders zur elektrischen Kontaktierung befestigt ist.

8. Kombination aus einem Reifenventil und einem Reifendrucksensor gemäß einem der Ansprüche 5 bis 7, **dadurch gekennzeichnet, dass** das Gehäuse (10) gelenkig an dem Reifenventil (16) angeschlossen ist.

## Claims

1. A button cell, particularly for a tire pressure sensor, with a first electric pole (2) formed by a first front side (1) and a second electric pole (4) formed by a second front side (3) opposite to the first front side (1);
with a first contact tab (6) mounted on the first front side (1), which first contact tab (6) includes a substantially flat extension inside the plane of the first front side (1) or with a first contact tab (6) formed by the first front side (1);
with a second contact tab (7) mounted on the second front side (3), which second contact tab (7) extends from the plane of the second front side (3) at an angle substantially up to the plane of the first front side (1);
with an insulation layer (8) mounted on the button cell, at least in the area of the first and second contact tabs (6, 7) or on the external periphery of the button cell;
**characterised in that**
the insulation layer (8) includes a plurality of openings, which traverse the insulation layer (8) completely and which are distributed over the surface of the insulation layer (8).

2. A button cell according to claim 1, **characterised in that** the insulation layer (8) is designed as a netting.

3. A button cell according to any of the claims 1 or 2, **characterised in that** the insulation layer (8) is designed as a netting tube, in particular a shrink netting tube stretched on the button cell.

4. A button cell according to one of the claims 1 to 3, **characterised in that** the first and/or the second contact tab (6, 7) penetrates the insulation layer (8) and is covered partially by the insulation layer (8).

5. A tire pressure sensor
with a housing (10);
with a pressure transducer (11) outside, on or inside the housing (10);
with transmitting electronics (12) on or inside the housing (10);
with a power supply (13);
**characterised in that**
the power supply (13) contains a button cell according to one of the claims 1 to 4.

6. A tire pressure sensor according to claim 5, **characterised in that** the pressure transducer (11), the transmitting electronics (12) and the button cell are positioned inside the housing (10) and the housing (10) is filled with a casting compound (14), at least partially, in particular over its whole base.

7. A tire pressure sensor according to one of the claims 5 or 6, **characterised in that** a circuit board (15) is provided in the housing (10), on which the button cell is soldered, clamped or fastened otherwise with both contact tabs (6, 7) to provide an electrical contact.

8. Combination of a tire valve and a tire pressure sensor according to one of the claims 5 to 7, **characterised in that** the housing (10) is connected in an articulated manner to the tire valve (16).

## Revendications

1. Pile-bouton, en particulier pour un capteur de pression de pneu, avec un premier pôle électrique (2) formé par une première face frontale (1) et un deuxième pôle électrique (4) formé par une deuxième face frontale (3) opposée à la première face frontale (1) ;
avec une première patte de contact (6) appliquée sur la première face frontale (1), qui s'étend de façon sensiblement plane dans le plan de la première face frontale (1), ou avec une première patte de contact (6) formée par la première face frontale (1) ;
avec une deuxième patte de contact (7) appliquée sur la deuxième face frontale (3), qui s'étend en formant un coude à partir du plan de la deuxième face frontale (3) sensiblement jusqu'au plan de la première face frontale (1) ;
avec une couche isolante (8) appliquée sur la pile-bouton, au moins au niveau des première et deuxième pattes de contact (6, 7), ou appliquée sur la circonférence extérieure de la pile-bouton ;
**caractérisée en ce que** la couche isolante (8) présente plusieurs ouvertures qui traversent complètement la couche isolante (8) et qui sont réparties sur la surface de la couche isolante (8).

2. Pile-bouton selon la revendication 1, **caractérisée en ce que** la couche isolante (8) est réalisée comme un filet.

3. Pile-bouton selon l'une des revendications 1 ou 2, **caractérisée en ce que** la couche isolante (8) est réalisée comme une gaine de filet passée par-dessus la pile-bouton, en particulier une gaine de filet rétractable.

4. Pile-bouton selon l'une des revendications 1 à 3, **caractérisée en ce que** la première patte de contact et/ou la deuxième (6, 7) traversent la couche isolante (8) et sont partiellement recouvertes par la couche isolante (8).

5. Capteur de pression de pneu
avec un boîtier (10) ;
avec un capteur de pression (11) à l'extérieur du boîtier (10), sur celui-ci ou à l'intérieur ;
avec un circuit électronique émetteur (12) sur le boîtier (10) ou à l'intérieur ; avec une alimentation électrique (13) ;
**caractérisé en ce que** l'alimentation électrique (13) comprend une pile-bouton selon l'une des revendications 1 à 4.

6. Capteur de pression de pneu selon la revendication 5, **caractérisé en ce que** le capteur de pression (11), le circuit électronique émetteur (12) et la pile-bouton sont positionnés à l'intérieur du boîtier (10) et le boîtier (10) est enrobé au moins en partie, de préférence sur toute sa surface de base, d'une masse d'enrobage (14).

7. Capteur de pression de pneu selon l'une des revendications 5 ou 6, **caractérisé en ce qu'**il est prévu dans le boîtier (10) une carte (15) sur laquelle la pile-bouton est brasée, serrée ou fixée d'une autre manière avec les deux pattes de contact (6, 7) pour établir un contact électrique.

8. Combinaison d'une valve de pneu et d'un capteur de pression de pneu selon l'une des revendications 5 à 7, **caractérisée en ce que** le boîtier (10) est raccordé de façon articulée à la valve de pneu (16).
